(19) Europäisches Patentamt
European Patent Office
Office européen des brevets

(11) **EP 4 592 270 A1**

(12) **EUROPEAN PATENT APPLICATION**
published in accordance with Art. 153(4) EPC

(43) Date of publication:
**30.07.2025 Bulletin 2025/31**

(21) Application number: 23867956.7

(22) Date of filing: 23.08.2023

(51) International Patent Classification (IPC):
*C04B 35/587* (2006.01)    *C04B 35/581* (2006.01)
*H01L 23/13* (2006.01)     *H01L 23/15* (2006.01)
*H05K 1/03* (2006.01)

(52) Cooperative Patent Classification (CPC):
**H01L 23/15; C04B 35/581; C04B 35/587;
H01L 23/13; H01L 23/49861; H05K 1/03**

(86) International application number:
**PCT/JP2023/030371**

(87) International publication number:
**WO 2024/062832 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.09.2022 JP 2022149523**

(71) Applicants:
• **Kabushiki Kaisha Toshiba**
  **Tokyo 105-0023 (JP)**

• **Toshiba Materials Co., Ltd.**
  **Isogo-Ku**
  **Yokohama-Shi**
  **Kanagawa 235-0032 (JP)**

(72) Inventors:
• **YAMAGATA, Yoshihito**
  **Yokohama-shi, Kanagawa 235-0032 (JP)**
• **AOKI, Katsuyuki**
  **Yokohama-shi, Kanagawa 235-0032 (JP)**

(74) Representative: **Henkel & Partner mbB**
  **Patentanwaltskanzlei, Rechtsanwaltskanzlei**
  **Maximiliansplatz 21**
  **80333 München (DE)**

(54) **CERAMIC SUBSTRATE, CERAMIC CIRCUIT SUBSTRATE, AND SEMICONDUCTOR DEVICE**

(57)    A ceramic substrate according to one embodiment is characterized in that the ratio A/B of an arc discharge voltage A to a dielectric breakdown voltage B is at least 0.3, in a case where a 50 Hz or 60 Hz alternating-current voltage is applied between the front surface and the rear surface of the ceramic substrate at a voltage rise speed of 200 V/s, and the arc discharge voltage A (kV) obtained by detecting an arc discharge is measured and the dielectric breakdown voltage B (kV) between the front surface and the rear surface is measured in accordance with IEC 672-2. In any cross-section of the ceramic substrate, it is preferable that there be a 90 $\mu$m $\times$ 120 $\mu$m region in which the number of first voids having a surface area of less than 1 $\mu m^2$ is within the range of 30 to 500, and the number of second voids having a surface area of at least 1 $\mu m^2$ is within the range of 0 to 30.

FIG. 2

EP 4 592 270 A1

## Description

[Technical Field]

Embodiments described below relate generally to a ceramic substrate, a ceramic circuit substrate, and a semiconductor device.

[Background Art]

The output of power modules mounted in industrial devices is increasing in recent years as the performance of industrial devices increases. Accordingly, the output of semiconductor elements is increasing. The guaranteed operating temperature of a semiconductor element is 125 °C to 150 °C, but there is a possibility of increasing to not less than 175 °C in the future. A ceramic circuit substrate is used as a circuit substrate to which a semiconductor element is mounted. Examples of the ceramic substrate include a silicon nitride substrate, an aluminum nitride substrate, an aluminum oxide substrate, etc.

For example, Japanese Patent No. 6293772 (Patent Literature 1) discusses a silicon nitride substrate of which the thermal conductivity is not less than 50 W/m·K, and the three-point bending strength is not less than 600 MPa. In Patent Literature 1, the distribution of a grain boundary phase in the thickness direction of a substrate is controlled. In Japanese Patent No. 5928896 (Patent Literature 2), the area ratio of voids having an equivalent circle diameter of not less than 0.5 µm is controlled.

[Prior Art Documents]

[Patent Literature]

Patent Literature 1: Japanese Patent No. 6293772
Patent Literature 2: Japanese Patent No. 5928896

[Summary of Invention]

[Problem to be Solved by the Invention]

The silicon nitride substrates described in Patent Literature 1 and Patent Literature 2 each have excellent insulative properties. On the other hand, there is still room for improvement from the perspective of long-term reliability. In a conventional insulation test, the dielectric strength is measured in a destructive test. In the withstand voltage test, electrodes are placed respectively at the front surface and back surface of the ceramic substrate; and the voltage at which dielectric breakdown occurs is measured. Some ceramic substrates have insufficient long-term reliability despite having high dielectric strength. An investigation of the cause showed that the conditions used in the withstand voltage test greatly deviated from practical electric fields, and there also may be cases where the measured dielectric strength is inappropriate as an indicator of the long-term reliability. For example, a practical voltage of a semiconductor device is about 1 kV, whereas a large voltage of about 9 kV is applied in the withstand voltage test. Embodiments are directed to address such problems, and to provide a ceramic substrate in which the long-term reliability of insulative properties can be obtained.

[Means for Solving the Problem]

A ceramic substrate according to an embodiment includes a ratio $A/B$ of an arc discharge voltage A to a dielectric breakdown voltage B of not less than 0.3 when the arc discharge voltage A (kV) is measured when an arc discharge is detected when applying an AC voltage of 50 Hz or 60 Hz between a front surface and a back surface of the ceramic substrate at a voltage increase rate of 200 V/s, and when the dielectric breakdown voltage B (kV) between the front surface and the back surface is measured according to IEC 672-2.

[Brief Description of Drawings]

[FIG. 1]

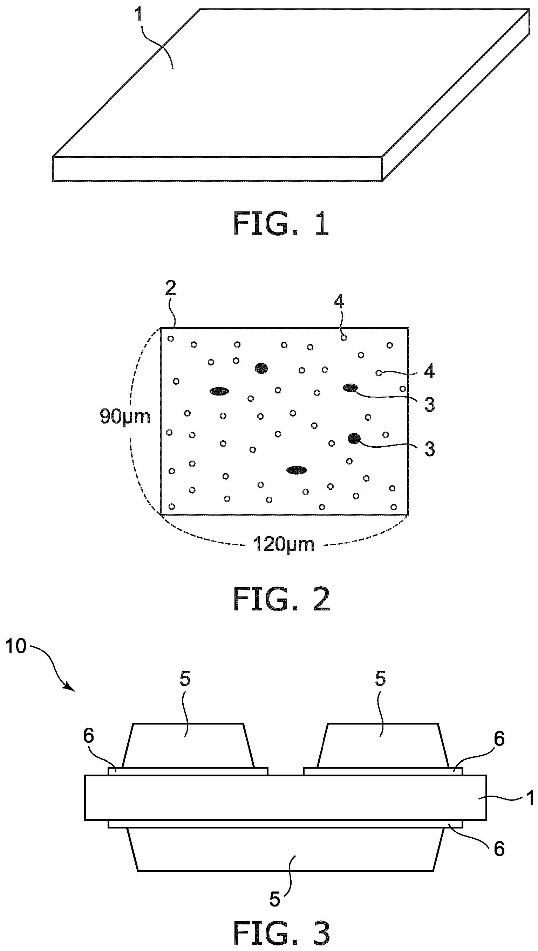

FIG. 1 is a schematic view showing an example of a ceramic substrate according to an embodiment.
[FIG. 2]
FIG. 2 is a schematic view showing an example of a cross-sectional structure of the ceramic substrate.
[FIG. 3]
FIG. 3 is a schematic view showing an example of a ceramic circuit substrate according to an embodiment.
[FIG. 4]

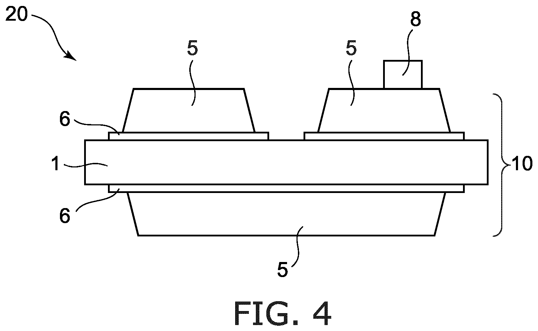

FIG. 4 is a schematic view showing an example of a semiconductor device according to an embodiment.

[Detailed Description]

A ceramic substrate according to an embodiment includes a ratio $A/B$ of an arc discharge voltage A to a dielectric breakdown voltage B of not less than 0.3 when the arc discharge voltage A (kV) is measured when an arc discharge is detected when applying an AC voltage of 50 Hz or 60 Hz between a front surface and a back surface of the ceramic substrate at a voltage increase rate of 200 V/s, and when the dielectric breakdown voltage B (kV) between the front surface and the back surface is measured according to IEC 672-2.

FIG. 1 is a schematic view showing an example of a ceramic substrate according to an embodiment. In FIG. 1, the reference numeral 1 is a ceramic substrate. FIG. 1 illustrates a rectangular substrate. Various shapes such as circular, elliptical, triangular, square, pentagonal, etc., are applicable to the ceramic substrate 1. A hole for fastening by screwing may be provided in the ceramic substrate 1 as necessary.

First, a method for measuring the arc discharge voltage will be described. Electrodes are placed respectively on the front surface and back surface of the ceramic substrate 1; and the ceramic substrate 1 is sandwiched between the pair of electrodes. An AC voltage of 50 Hz or 60 Hz is applied between the electrodes in this state. The voltage increase rate is set to 200 V/s. The voltage when an arc discharge is detected between the electrodes is measured to be the arc discharge voltage (kV). When the arc discharge voltage is measured, the application of the voltage is stopped without increasing the voltage further.

For example, spherical electrodes of which the tips have diameters of 10 mm as defined in JIS-C-2110-1 (2013) are used as the electrodes. JIS-C-2110-1 corresponds to IEC 60243-1. For the measurement environment, the temperature is controlled to 10 to 25 °C; the humidity is controlled to 30 to 60%; and the measurement is performed in ambient air. Or, the arc discharge voltage may be measured in an insulating oil that is stable with respect to the electric field such as silicone oil, etc.

The arc discharge voltage is measured at any three locations of one ceramic substrate; and the average value of the arc discharge voltages is recorded as the arc discharge voltage A (kV). Any three locations are selected not to overlap each other. Also, the maximum voltage is up to 20 kV. The ceramic substrate 1 to be measured is stored inside a container so that the measurement is not affected by airflow. It is favorable to use the AC withstand voltage tester-7473 made by Keisoku Giken as the measurement device. Or, a device that has an equivalent or better arc discharge detection function may be used. The voltage divided by the thickness of the ceramic substrate, i.e., "kV/mm", may be used as the units of the arc discharge voltage A.

The dielectric breakdown voltage is measured in accordance with the dielectric breakdown strength test of JIS-C-2141 (1992). JIS-C-2141 corresponds to IEC 672-2. The test is performed using a two-terminal method. Electrodes are placed respectively on the front surface and back surface of the ceramic substrate 1; and the ceramic substrate 1 is sandwiched between the pair of electrodes. An AC voltage of 50 Hz or 60 Hz is applied between the electrodes in this state; and the AC voltage is increased. The voltage increase rate is set to 200 V/s. The voltage when dielectric breakdown of the ceramic substrate 1 occurs is measured as the dielectric breakdown voltage B (kV).

For example, spherical electrodes of which the tips have diameters of 10 mm as defined in JIS-C-2110-1 (2013) are used as the electrodes. The conditions of the electrodes when measuring the dielectric breakdown voltage B are the same as the conditions of the electrodes when measuring the arc discharge voltage A. The maximum voltage is set to 20 kV. The voltage divided by the thickness of the ceramic substrate 1, i.e., "kV/mm" may be used as the units of the dielectric breakdown voltage B. The units of the arc discharge voltage and the units of the dielectric breakdown voltage are unified to one of "kV" or "kV/mm".

The electrodes, voltage increase rate, and measurement environment when measuring the dielectric breakdown voltage are set to be respectively the same as the electrodes, voltage increase rate, and measurement environment when measuring the arc discharge voltage. Also, when the size of the ceramic substrate is small, a catalog value may be used as the dielectric breakdown voltage of the ceramic substrate 1. As a guide for the size, it is favorable to use the catalog value when one side is less than 5 mm.

For the ceramic substrate 1 according to the embodiment, the ratio $A/B$ is not less than 0.3 when the arc discharge voltage A (kV) and the dielectric breakdown voltage B (kV) are measured by the method described above.

The arc discharge is detected as a pulse current that is periodically generated when an AC electric field having a constant frequency is applied to the ceramic substrate 1. For example, the arc discharge occurs easily at structures at which the electric field concentrates. The arc discharge occurs at voids, etc., inside the ceramic substrate 1. When the voltage is applied to the ceramic substrate 1, a shared voltage is applied to the voids, etc. The shared voltage is due to the voltage gradient generated by a resistance value different from that of the ceramic, and in the case of a void, the magnitude of the shared voltage changes according to the size and/or shape of the void. When the shared voltage reaches the discharge voltage of the voids, etc., a partial discharge that is the origin of the arc discharge occurs. The state in which a pulse current generated by this partial discharge periodically appears is determined to be the occurrence of an arc discharge. The voltage at which the occurrence of the arc discharge starts is detected and measured as the arc discharge voltage A.

The voltage at which a current is conducted between the front surface and the back surface of the ceramic substrate is measured as the dielectric breakdown voltage. That is, the structural breakdown voltage at which the ceramic substrate 1 is short-circuited is measured as the dielectric breakdown voltage B.

Switching frequencies are increasing in recent years as the performance of semiconductor elements increases. Examples of power semiconductor elements include a Si element, a SiC element, a GaN element, etc. The switching frequencies of these elements vary from several 10 Hz to several 100 kHz. Also, in recent years, there are semiconductor elements having switching frequencies of about 1 G. The current is repeatedly switched on and off according to the switching frequency. There is a possibility that an arc discharge may occur when the current is repeatedly switched on and off. When the current is repeatedly switched on and off, the arc discharge occurs more easily as the arc discharge voltage of the ceramic substrate decreases. The insulative properties of the ceramic substrate degrade when the occurrence of the arc discharge is repeated. Therefore, the long-term insulative properties of the ceramic substrate cannot be maintained. That is, the insulative properties of the ceramic substrate degrade even when the dielectric breakdown voltage has not been reached.

Generally, the switching frequency of a Si-IGBT element, which is one type of Si element, is about 100 Hz to 50 kHz. The switching frequency of a SiC-MOS element is about 8 kHz to 1 MHz. The output power and the power density increase as the switching frequency increases. For example, among Si-IGBT elements having a switching frequency of 25 kHz, there is an element having an output power 3.3 kW and a power density of about 0.3 $W/cm^3$. Among SiC-MOS elements having a switching frequency of 160 kHz, there is an element having an output power 5 kW and a power density of about 1.8 $W/cm^3$. Among GaAs-MESFETs (Metal semiconductor FETs) and HEMTs (High Electron Mobility Transistors), there is also an element having a switching operating frequency of 1 G to 10 G. An increase of the switching frequency causes an increase of the output voltage or the power density.

The ceramic substrate according to the embodiment has excellent insulative properties even when the switching frequency is high and is not less than 8 kHz. Also, the insulative properties are excellent even when a semiconductor element that has an output power of not less than 1 W, or a power density of not less than 1 $W/cm^3$ is mounted. In other words, for a ceramic substrate used in a semiconductor device including a semiconductor element having higher performance, the insulative properties cannot be appropriately evaluated using only the dielectric breakdown voltage.

In the ceramic substrate 1 according to the embodiment, the ratio $A/B$ is not less than 0.3 when the arc discharge voltage A (kV) and the dielectric breakdown voltage B (kV) are measured. This means that the arc discharge voltage A is not less than 0.3 times the dielectric breakdown voltage B. On the other hand, the ratio $A/B$ being less than 0.3 means that the arc discharge voltage A is less than 0.3 times the dielectric breakdown voltage B. When a ceramic substrate that has a ratio $A/B$ of less than 0.3 is used, there are cases where insulation defects of the ceramic substrate may occur when a semiconductor element having a high switching frequency is mounted and used, even if the dielectric breakdown voltage is high. In other words, there are cases where a ceramic substrate that has a ratio $A/B$ of less than 0.3 has poor long-term reliability.

The arc discharge is detected as a pulse current periodically generated when an AC electric field having a constant frequency is applied between the electrodes. The initial arc discharge phenomenon occurs due to voids, etc., inside the ceramic substrate. A phenomenon called arc degradation occurs when arc discharge is repeated. Dielectric breakdown occurs as arc degradation proceeds. That is, arc discharge is a precursor of dielectric breakdown. Therefore, the long-term reliability of the ceramic substrate can be checked by measuring the voltage at which arc discharge occurs.

In particular, the number of pulse currents periodically generated increases as the switching frequency of the semiconductor element increases. The arc discharge inside the ceramic substrate occurs more easily when the output voltage and the power density increase. Accordingly, even in a state in which dielectric breakdown of the ceramic substrate has not occurred, the insulative properties inside the ceramic substrate degrade more easily due to arc discharge as the switching frequency, the output voltage, and the power density increase. As a result, long-term reliability problems may occur.

The ratio $A/B$ being not less than 0.3 means that the arc discharge voltage A is high compared to a conventional ceramic substrate. Accordingly, the arc discharge does not occur easily, even when the output voltage and the power density of the semiconductor element are large. By suppressing the occurrence of arc discharge, the number of occurrences of arc discharge can be suppressed even when the switching frequency of the semiconductor element that is mounted is high. In other words, the suppression of the occurrence of arc discharge may cause the increase of the reliability of a semiconductor device in which a semiconductor element having a high switching frequency is mounted.

The upper limit of the ratio $A/B$ is 1.0. The ratio $A/B$ = 1.0 means a state in which the arc discharge voltage and the dielectric breakdown voltage are substantially equal, or a state in which arc discharge is substantially not observed. The ratio $A/B$ = 1.0 means that even when an AC electric field having a constant frequency is applied between the electrodes, the ceramic substrate does not include a structure that generates a periodic pulse current. There are also cases where voids are substantially not present in the ceramic substrate, and there are also cases where voids are present but arc discharge cannot be detected (including being below the detection limit). In such cases, the long-term reliability cannot be predicted. It is therefore favorable for the ratio $A/B$ to be within the range of not less than 0.3 but less than 1.0, or even not less than 0.5 and not more than 0.9.

In the ceramic substrate according to the embodiment, it is favorable for a 90 $\mu$m$\times$120 $\mu$m region to be present in any cross section in which the number of voids having areas of less than 1 $\mu$m$^2$ is within the range of not less than 30 and not more than 500, and the number of voids having areas of not less than 1 $\mu$m$^2$ is within the range of not less than 0 and not more than 30. For convenience of description herein, voids that have areas of less than 1 $\mu$m$^2$ are called "small voids" (first voids); and voids that have areas of not less than 1 $\mu$m$^2$ are called "large voids" (second voids).

FIG. 2 is a schematic view showing an example of a cross-sectional structure of the ceramic substrate. In FIG. 2, the reference numeral 2 is the cross section of the ceramic substrate, the reference numeral 3 is large voids having areas of not less than 1 $\mu$m$^2$, and the reference numeral 4 is small voids having areas of less than 1 $\mu$m$^2$. In FIG. 2, the large voids 3 are illustrated by being filled-in with black; and the small voids 4 are illustrated as white with black outlines.

A method for observing the cross section will now be described. First, any cross section of the ceramic substrate is prepared. A polished surface of which the surface roughness Ra is not more than 1 $\mu$m is used as the cross section. The cross section is observed using a scanning electron microscope (SEM); and an enlarged photograph of 1,000 times is imaged. JCM-7000 or JSM-7200F made by JOEL or a device having equivalent or better performance is used for the SEM. The large voids 3 having areas of not less than 1 $\mu$m$^2$ and the small voids 4 having areas of less than 1 $\mu$m$^2$ are observed in the enlarged photograph that is imaged.

To observe the voids, the SEM photograph is analyzed using image analysis software. ImageJ or equivalent or better software is used as the image analysis software. Contrast occurs between the voids and other portions in the SEM photograph of the cross section. For example, the color of voids appear blacker and darker than the colors of portions other than voids. The contrast can be utilized to discriminate between the voids and the other portions by binarizing the SEM photograph. Voids of not less than 0.01 $\mu$m$^2$ are counted as small voids. This is because voids having areas of less than 0.01 $\mu$m$^2$ are difficult to discriminate in an enlarged photograph of 1,000 times.

A value that is obtained using a "mode technique" or a "discriminant analysis binarization technique" is used as the threshold for binarization. When the image analysis software includes the function of a discriminant analysis binarization technique, the discriminant analysis binarization technique of the image analysis software is used. In the discriminant analysis binarization technique, the threshold is determined uniquely by the analysis software. It is therefore easy to discriminate the voids. For example, in the SEM photograph, the region that appears white around the void is the boundary between the void and the silicon nitride sintered body. Accordingly, the region that appears white around the void should not be counted as the void. Also, the silicon nitride sintered body is gray in the SEM photograph. By using the threshold obtained by the "mode technique" or the "discriminant analysis binarization technique", the void can be shown as black; and the silicon nitride sintered body and the white region around the void can be shown as white. By using a binarized image, the voids that are visible in the SEM photograph and the other regions can be discriminated.

The observation area of the SEM is set to a size of 180 $\mu$m$\times$430 $\mu$m. Three areas are observed, and a 90 $\mu$m$\times$120 $\mu$m region in which the most voids are observed is selected from among the areas. When a 180 $\mu$m$\times$430 $\mu$m area cannot be observed in one field, a 180 $\mu$m$\times$430 $\mu$m area may be observed by dividing into multiple observations. In such a case, the minimum size of the observed area is set to 90 $\mu$m$\times$120 $\mu$m. Also, the orientation of the sample with respect to the 180 $\mu$m$\times$430 $\mu$m observation area and the 90 $\mu$m$\times$120 $\mu$m region is arbitrary. In any cross section, the orientation of the 180 $\mu$m$\times$430 $\mu$m observation area and the orientation of the 90 $\mu$m$\times$120 $\mu$m region may be adjusted so that the most voids are observed.

It is favorable for a 90 $\mu$m$\times$120 $\mu$m region to be present in any cross section in which the number of the large voids 3 is within the range of not less than 0 and not more than 30. The large voids 3 effect both the arc discharge voltage and the dielectric breakdown voltage. In particular, the large voids 3 cause a reduction of the arc discharge voltage. It is therefore favorable for the number of the large voids 3 to be within the range of not less than 0 and not more than 30, or even not less than 0 and not more than 20.

It is favorable for a 90 $\mu$m$\times$120 $\mu$m region to be present in any cross section in which the number of the small voids 4 is within the range of not less than 30 and not more than 500. The small voids 4 have little effect on the arc discharge voltage and the dielectric breakdown voltage. When, however, the number of the small voids 4 is large and is greater than 500, the arc discharge characteristics are affected. When the number of small voids is less than 30, the insulative properties are improved. On the other hand, to manufacture a ceramic substrate in which the number of the small voids 4 is less than 30, hot isostatic press (HIP) processing or the like is necessary, which may increase the cost.

Also, when the small voids 4 are present, the deflection amount of the ceramic substrate 1 can be increased. The deflection amount refers to the amount of "deformation" from the horizontal state when stress is applied to a ceramic substrate placed horizontally. For example, the deflection length when two ends of the ceramic substrate are fixed and the middle is pressed is called the "deflection amount". The ceramic circuit substrate is fixed by fastening by screwing, etc. When the deflection amount is large, damage of the ceramic substrate can be suppressed even when the stress of fastening by screwing is applied. It is therefore favorable for the number of the small voids 4 present in a 90 $\mu$m×120 $\mu$m unit area to be within the range of not less than 30 and not more than 500, and more favorably within the range of not less than 40 and not more than 400.

The number of the large voids 3 and the number of the small voids 4 described above are the numbers counted when the 90 $\mu$m×120 $\mu$m region having the most voids is observed in any cross section. Therefore, when the cross section is observed, there may be regions in which the number of the large voids 3, the number of the small voids 4, the area ratio described below, etc., are less than the prescribed ranges. In other words, in the ceramic substrate 1 according to the embodiment, when 180 $\mu$m×430 $\mu$m areas are observed at three locations, there is at least one region in which the number of the large voids 3 and the number of the small voids 4 are within the prescribed ranges. Favorably, the number of the large voids 3 and the number of the small voids 4 are greater than the prescribed ranges in none of the 90 $\mu$m×120 $\mu$m regions that are observed. For example, 180 $\mu$m×430 $\mu$m areas at any three locations may be observed, and it may be determined that there are no locations at which the number of the large voids 3 and the number of the small voids 4 are greater than the prescribed ranges.

The ratio of arc discharge voltage A/dielectric breakdown voltage B can be controlled by controlling the number of the large voids 3 and the number of the small voids 4. Furthermore, in addition to controlling the number of the large voids 3 and the number of the small voids 4, it is favorable for the total area ratio of the small voids 4 present in the 90 $\mu$m×120 $\mu$m region to be within the range of not less than 0.01% and not more than 0.8%. By controlling the area ratio of the small voids 4, both the insulative properties and the deflection amount can be realized. Also, in addition to controlling the number of the large voids 3 and the number of the small voids 4, it is favorable for the total area ratio of the large voids 3 present in the 90 $\mu$m×120 $\mu$m region to be within the range of not less than 0% and not more than 0.6%. Even when the number of the large voids 3 is within the prescribed range, if the total area ratio is large and is greater than 0.6%, there is a possibility that this may cause degradation of the insulative properties.

The area ratio of the large voids 3 and the area ratio of the small voids 4 described above are calculated in a 90 $\mu$m×120 $\mu$m region in which a prescribed numbers of large voids 3 and small voids 4 are present. That is, in the ceramic substrate 1 according to the embodiment, the numbers of the large voids 3 and the small voids 4 are controlled, and a region is present in which the area ratio also is controlled.

It is favorable for the maximum diameter of the voids present in a 90 $\mu$m×120 $\mu$m region to be not more than 15 $\mu$m. First, when the cross section is observed, the major diameters of the voids visible in the photograph are measured. The "major diameter" is the distance between the two most distant points present on the outer edge of the void. The largest value among the major diameters of multiple voids is used as the "maximum diameter". By setting the maximum diameter of the voids to be not more than 15 $\mu$m, the degradation of the insulative properties of the ceramic substrate 1 can be suppressed.

The maximum diameter of the voids is measured in the 90 $\mu$m×120 $\mu$m region in which the most voids are observed. More favorably, the maximum diameter of the voids in three 180 $\mu$m×430 $\mu$m areas is not more than 15 $\mu$m. The three areas for measuring the maximum diameter may be the same as the three 180 $\mu$m×430 $\mu$m areas observed when counting the number of voids.

Also, in a 90 $\mu$m×120 $\mu$m region, it is favorable for the number of sets of which the distances between the large voids 3 are not more than 5 $\mu$m to be not less than 0 and not more than 3. The number of sets of the large voids 3 is counted in the 90 $\mu$m×120 $\mu$m region in which the most voids are observed. When the distance between one large void 3 and another large void 3 is not more than 5 $\mu$m, the large voids 3 are counted as one set. When two large voids 3 are present within a range of 5 $\mu$m from one large void 3 used as a reference, the large void 3 that is used as the reference and each of the two large voids 3 are counted as two sets. When three or more large voids 3 are present within a range of 5 $\mu$m from one large void 3, the large voids 3 are counted as three or more sets. For example, when three large voids 3 are distributed in a triangle separated by distances of not more than 5 $\mu$m, the large voids 3 are counted as three sets.

The distance is measured using the enlarged photograph of the observed cross section. Ranges of 5 $\mu$m are set around the observed large voids 3; and the number of sets is counted when other large voids 3 are present within the ranges. Subsequently, when a range of 5 $\mu$m is set using another large void 3 as a center, a set that has been counted once is not counted again.

When the distance between the large voids 3 is short, there is a possibility that the large voids 3 may undesirably have a function similar to that of a larger void. For example, when the number of sets of the large voids 3 of which the distances between the large voids 3 are not more than 5 $\mu$m is greater than 3, there is a possibility that the arc discharge voltage and the dielectric breakdown voltage may drop, and the insulative properties of the ceramic substrate 1 may degrade. It is therefore favorable for the number of sets of the large voids 3 of which the distances between large voids 3 are not more than 5 μm to be within the range of not less than 0 and not more than 3, and more favorably within the range of not less than 0 and not more than 1. Sets of the large voids 3 and the small voids 4 are not counted, even when the small voids 4 are present proximate to the large voids 3. This is because there is little unfavorable effect on the insulative properties even when the large voids 3 and the small voids 4 are proximate to each other. Here, only the sets of the large voids 3 of which the distances between the large voids 3 are not more than 5 μm are counted.

Two or more conditions selected from the number of voids, the total area ratio, the maximum diameter of the voids, and the number of sets of the large voids 3 can be combined. Most favorably, there is a region in any cross section in which all of the number of voids, the total area ratio, the maximum diameter, and the number of sets of the large voids 3 are within the ranges described above.

The ceramic substrate 1 is one selected from a silicon nitride substrate, an aluminum nitride substrate, an aluminum oxide substrate, and an Alusil substrate. An Alusil substrate is a substrate that includes both aluminum oxide and zirconium oxide. Among the ceramic substrates, a silicon nitride substrate is favorable. The thermal conductivity of a silicon nitride substrate is not less than 40 W/m·K, or even not less than 80 W/m·K. Also, the three-point bending strength of a silicon nitride substrate is not less than 600 MPa, or even not less than 700 MPa.

The thermal conductivity of an aluminum nitride substrate is not less than 160 W/m·K, or even not less than 200 W/m·K. The three-point bending strength of an aluminum nitride substrate is about 300 to 450 MPa. The three-point bending strength of an aluminum oxide substrate is about 300 to 450 MPa, but an aluminum oxide substrate is inexpensive compared to other substrates. Also, the thermal conductivity of an aluminum oxide substrate is about 20 to 30 W/m·K. The three-point bending strength of an Alusil substrate is high and is about 550 MPa, but the thermal conductivity is about 30 to 50 W/m·K.

It is favorable for the thickness of the ceramic substrate 1 to be within the range of not less than 0.2 mm and not more than 3 mm. When the thickness is less than 0.2 mm, there is a possibility that the insulative properties of the ceramic substrate 1 may be insufficient. When the thickness is greater than 3 mm, the insulative properties of the ceramic substrate 1 are good, but the heat dissipation may degrade.

For the silicon nitride substrate to be strong, the thickness of the substrate can be within the range of not less than 0.2 mm and not more than 0.8 mm, or even within the range of not less than 0.2 mm and not more than 0.4 mm. Also, by controlling the voids, both the insulative properties and the deflection amount can be realized. When the thicknesses of two ceramic substrates are the same, the ceramic substrate that has a large deflection amount cracks less easily.

It is favorable for the arc discharge voltage A to be not less than 5 kV/mm for a ceramic substrate 1 of which a dielectric breakdown voltage B of not less than 10 kV/mm is guaranteed. By setting the arc discharge voltage to be not less than 5 kV/mm, $A/B$ can be not less than 0.3, or even not less than 0.5. It is therefore favorable for the ceramic substrate 1 to be a silicon nitride substrate having an arc discharge voltage of not less than 5 kV/mm.

Such a ceramic substrate is applicable to a ceramic circuit substrate. FIG. 3 is a schematic view showing an example of a ceramic circuit substrate according to an embodiment. In FIG. 3, the reference numeral 1 is a ceramic substrate, the reference numeral 5 is a metal part, the reference numeral 6 is a bonding layer, and the reference numeral 10 is a ceramic circuit substrate.

In the example shown in FIG. 3, two metal parts 5 are bonded to the front side of the ceramic substrate 1; and one metal part 5 is bonded to the backside of the ceramic substrate 1. The ceramic circuit substrate 10 according to the embodiment is not limited to such a shape. The ceramic substrate 1 may include the necessary number of metal parts 5. Also, in the example shown in FIG. 5, the metal part 5 that is used as a circuit is bonded to the front side; and the metal part 5 that is used as a heat dissipation plate is bonded to the backside. The metal part 5 is not limited to the example; the metal parts 5 that are used as circuits may be bonded to two surfaces of the ceramic substrate 1. It is favorable for the bonding layer 6 to be formed using an active metal brazing material.

FIG. 4 is a schematic view showing an example of a semiconductor device according to an embodiment. In FIG. 4, the reference numeral 8 is a semiconductor element, the reference numeral 10 is a ceramic circuit substrate, and the reference numeral 20 is a semiconductor device.

As shown in FIG. 4, the semiconductor device 20 can be made by mounting the semiconductor element 8 to the metal part 5 of the ceramic circuit substrate 10. In the example shown in FIG. 4, one semiconductor element 8 is mounted to one metal part 5. Multiple semiconductor elements 8 may be mounted respectively on multiple metal parts 5. Multiple semiconductor elements 8 may be mounted to one metal part 5. Other than the semiconductor element 8, a leadframe, wire bonding, etc., may be bonded to the metal part 5. By improving the arc discharge voltage of the ceramic substrate 1, the long-term reliability of the insulative properties of the semiconductor device 20 can be ensured even when the semiconductor element 8 that has a high switching frequency is mounted.

A method for manufacturing the ceramic substrate 1 according to the embodiment will now be described. As long as the ceramic substrate 1 according to the embodiment has the configuration described above, the method for manufacturing the ceramic substrate 1 is not particularly limited. Here, an example of a method for obtaining the ceramic substrate 1 with a high yield will be described. A method for manufacturing a silicon nitride substrate is described in the following example.

First, a silicon nitride powder and a sintering aid powder that are used as raw materials are prepared. A silicon nitride powder that is manufactured by imide decomposition or direct nitriding is used. It is favorable for the average particle size of the silicon nitride powder to be within the range of not less than 0.1 $\mu$m and not more than 4 $\mu$m. At least one selected from a rare-earth element, titanium (Ti), hafnium (Hf), magnesium (Mg), and calcium (Ca) is used as the sintering aid. A compound of these elements may be used. Examples of the compound include an oxide, a nitride, an oxynitride, etc. Examples of the rare-earth element include yttrium (Y) and lanthanoid element. Examples of the lanthanoid element include ytterbium (Yb), erbium (Er), europium (Eu), lutetium (Lu), lanthanum (La), cerium (Ce), dysprosium (Dy), etc. It is favorable for the average particle size of the sintering aid powder to be within the range of not less than 0.1 $\mu$m and not more than 4 $\mu$m.

It is favorable to control the amount of impurities included in the silicon nitride powder and the sintering aid powder. Examples of the impurity to be controlled include Fe and carbon. A mixture of a silicon nitride powder and a sintering aid powder is called a raw material mixed powder. It is favorable for the Fe amount of the raw material mixed powder to be not more than 0.05 mass%. Also, it is favorable for the carbon amount of the raw material mixed powder to be not more than 0.5 mass%.

Fe and carbon that are present in the raw material mixed powder as impurities may cause structural defects in the sintered body. For example, Fe dissolves in the liquid phase when sintering and markedly reduces the liquid phase viscosity of the dissolved portion. In liquid-phase sintering, densification proceeds by grain boundary diffusion. In portions where the liquid phase viscosity degrades, defects such as voids, etc., occur easily because the rate of the grain boundary diffusion changes. In particular, iron that is included as an impurity easily causes voids. Also, carbon has a strong reduction effect and easily causes defects such as voids, etc.

To control the Fe amount and the carbon amount of the raw material mixed powder, it is effective to use a silicon nitride powder and a sintering aid powder having a low Fe amount and a low carbon amount. A method of preventing the mixing of impurities in the manufacturing processes also is effective. When the Fe amount included in the raw material mixed powder is high, a method of removing Fe with a magnet also is effective. By controlling the Fe amount and the carbon amount, a void distribution that does not affect the arc discharge characteristics can be obtained.

It is also effective to control fluorine (F) or chlorine (Cl) present as an impurity in the raw material mixed powder. It is favorable for the total content of fluorine or chlorine in the raw material mixed powder to be not less than 0 wtppm and not more than 1,000 wtppm. It is favorable for the total content of fluorine or chlorine in the sintered body to be not less than 0 wtppm and not more than 1,000 wtppm.

Fluorine and chlorine are elements that are easily included in the silicon nitride powder. The method for manufacturing the silicon nitride powder is mainly imide decomposition or direct nitriding. In imide decomposition, silicon halide is used as a raw material. In direct nitriding, a fluorine compound is used as a catalyst to nitride metallic silicon. Therefore, fluorine or chlorine tends to remain in the silicon nitride powder.

Also, because the electronegativity of fluorine or chlorine is large, anion defects easily occur in the sintered body. Therefore, there is a possibility that arc discharge may be caused. Accordingly, it is favorable for the total content of fluorine or chlorine in the raw material mixed powder to be not less than 0 wtppm and not more than 1,000 wtppm, and more favorably not less than 0 wtppm and not more than 400 wtppm. As a result, the content of fluorine or chlorine included in the silicon nitride sintered body can be set to be not more than 1,000 wtppm, or even not less than 0 wtppm and not more than 400 wtppm.

The silicon nitride powder and the sintering aid powder are mixed, and then further mixed in a mixing process using a pulverizer. Examples of the pulverizer include a ball mill or a bead mill. In the mixing process, a raw material powder slurry is made by adding a binder, a solvent, etc., to the silicon nitride powder and the sintering aid powder. Also, it is favorable for the raw material powder slurry to have hysteresis. Controlling thixotropy is effective for providing the slurry with hysteresis. Thixotropy is a property in which the apparent viscosity decreases over time when a constant shear stress is continuously applied, and then the apparent viscosity gradually recovers when the force is removed. It is considered that the apparent viscosity reflects the internal structure of the cohesive state of the slurry, etc. JIS-R-1665 (2005) defines the evaluation of thixotropy by using hysteresis measurements of flow curves.

To provide the slurry with hysteresis, it is effective to increase the thixotropic index (the TI index) which is the indicator of the thixotropy. To increase the thixotropic index, for example, it is favorable to increase particle concentration in the slurry and to use a poor solvent for particle dispersibility. When the particle concentration of the slurry is high, interactions between particles can be increased, and the dispersion state of the particles can be nonuniformity. As a result, the distribution of the particles in the compact can be somewhat nonuniform with uneven density. Voids occurs more easily in densification when sintering; and the void distribution can be controlled. It is favorable for the thixotropic index (the TI index) to be not less than 1.5 and not more than 5.

The TI index is measured using a rotational viscometer in accordance with JIS-R-1665 (2005). For a fluid that has cohesion, the viscosity generally decreases as the shear rate is continuously increased by the rotational viscometer. At this time, the ratio of a viscosity $\eta$ at a shear rate a to the viscosity $\eta$ at a shear rate b is the TI index. In other words, the TI index is represented by the following formula.

$$\text{TI index} = \eta a / \eta b$$

The viscosity $\eta$ is measured with the shear rate a set to 4 (1/s); and the viscosity $\eta$ is measured with the shear rate b set to 40 (1/s). The TI index is calculated by $\eta a / \eta b$. As the TI index approaches 1, the behavior of a Newtonian fluid is approached, meaning that it is a highly dispersed slurry with no cohesion or with extremely weak cohesion.

The TI index being not less than 1.5 means that the slurry is slightly cohesive. By being cohesive, the void distribution of the molded body can be controlled. Also, when the TI index is greater than 5, there is a possibility that the cohesion may be too strong, and there may be too many voids. It is therefore favorable for the TI index of the slurry to be within the range of not less than 1.5 and not more than 5, and more favorably within the range of not less than 2.1 and not more than 3.7. The compact is made by using a slurry of which the TI index is controlled. A known molding method such as a doctor blade, die molding, or the like is applicable as the molding process. The construction of a compact in a sheet-like shape is called sheet molding.

Then, a drying process of drying the compact is performed. It is favorable to derive a constant rate drying period and a reduced rate drying period based on the weight loss behavior of the solvent, and to set the temperature and time of the drying process based on the constant rate drying period and the reduced rate drying period. At the beginning of the drying, there is a sufficient amount of the solvent inside the ceramic compact, and a continuous layer of the solvent is present at the interfaces of the ceramic particles. The constant rate drying period is a period in which the solvent of the ceramic compact evaporates at a substantially constant ratio through the continuous layer. On the other hand, the reduced rate drying period is a period in which the solvent inside the ceramic compact evaporates in a state in which the continuous layer of the solvent is discontinuous. Contraction stress applied to the compact is a maximum in the transitional period from the constant rate drying period to the reduced rate drying period. Therefore, controlling the constant rate drying period, the reduced rate drying period, and the transitional period leads to the control of voids.

It is favorable for the weight reduction rate of the solvent in the constant rate drying period to be not less than 1 mass%/min. Although the upper limit of the weight reduction rate of the solvent in the constant rate drying period is not particularly limited, it is favorable for the upper limit to be not more than 10 mass%/min. When the weight reduction rate is greater than 10 mass%/min, there is a possibility that the voids may become large. It is therefore favorable for the weight reduction rate of the solvent in the constant rate drying period to be within the range of not less than 1 mass%/min and not more than 10 mass%/min.

It is favorable for the weight reduction rate of the solvent in the reduced rate drying period to be slower than the weight reduction rate of the solvent in the constant rate drying period. Also, it is favorable for the ratio of the weight reduction rates (the weight reduction rate of the solvent in the constant rate drying period divided by the weight reduction rate of the solvent in the reduced rate drying period) to be greater than 1 and not more than 20. As a result, the solvent inside the ceramic compact can be evaporated in the reduced rate drying period via the evaporation route of the solvent formed in the constant rate drying period. When the ratio of the weight reduction rates (the weight reduction rate of the solvent in the constant rate drying period divided by the weight reduction rate of the solvent in the reduced rate drying period) is greater than 20, there is a possibility that the drying rate may be too fast, which may cause large voids. When the weight reduction rate of the reduced rate drying period is slow, the manufacturing efficiency decreases.

After the drying process, a degreasing process is performed on the compact. It is favorable for the degreasing process to be performed within the range of not less than 400 °C and not more than 800 °C. The degreasing process can remove organic substances such as the binder, etc. The remaining solvent also is removed.

Then, a sintering process is performed. The sintering process is performed by heating the compact in the nonoxidizing atmosphere within a temperature range of not less than 1,650 °C and not more than 1,950 °C for not less than 4 hours and not more than 24 hours. A nitrogen gas atmosphere or a reducing atmosphere including nitrogen gas is favorable as the nonoxidizing atmosphere. It is favorable for the pressure inside the furnace to be a pressurized atmosphere. It is difficult to obtain a dense sintered body when the compact is fired at a sintering temperature of less than 1,650 °C. On the other hand, when the compact is fired at a sintering temperature that is greater than 1,950 °C, self-decomposition of $Si_3N_4$ occurs easily, and it is difficult to obtain a dense sintered body. As a result, it is favorable for the sintering temperature to be controlled within the range described above.

It is favorable to perform a heat treatment process in the temperature increase process from the degreasing process to the sintering process. In the heat treatment process, the compact is held within the range of not less than 1,400 °C and not more than 1,650 °C for not less than 1 hour and not more than 8 hours. This processing promotes and controls diffusion of the liquid phase made of the sintering aid, and helps control the voids of the sintered body.

(Examples)

(Examples 1 to 9 and comparative examples 1 to 3)

A silicon nitride substrate or an aluminum nitride substrate was made as the ceramic substrate. The mixing ratios of the silicon nitride powder and the sintering aid powders, which were the raw material powders, were as shown in Table 1. The mixing ratio was the value when the total of the sintering aid powders and one of the silicon nitride powder or the aluminum nitride powder was taken to be 100 mass%. For each of the examples and the comparative examples, the Fe amount in the raw material mixed powder was set to be not more than 0.05 mass%, and the carbon amount was set to be not more than 0.5 mass%. Also, the total amount of fluorine and chlorine in the raw material mixed powder was set to be not more than 1,000 wtppm.

[Table 1]

| | Mixing ratio (mass%) |
|---|---|
| Example 1 | $Si_3N_4(89),Y_2O_3(4),Er_2O_3(4),MgO(1),TiO_2(1),HfO_2(1)$ |
| Example 2 | $Si_3N_4(92),Y_2O_3(6),MgO(0.7),HfO_2(1.3)$ |
| Example 3 | $Si_3N_4(93),Y_2O_3(5),MgO(2)$ |
| Example 4 | $Si_3N_4(93),Er_2O_3(6),MgO(1)$ |
| Example 5 | $Si_3N_4(88),Y_2O_3(5),Er_2O_3(4),MgO(1.5),TiO_2(1),HfO_2(0.5)$ |
| Example 6 | $AlN(95),Y_2,O_3(5)$ |
| Example 7 | $AlN(97),Y_2O_3(3)$ |
| Example 8 | $Si_3N_4(92.8),Y_2O_3(5),MgO(1.2),HfO_2(1.0)$ |
| Example 9 | $Si_3N_4(93.2),Y_2O_3(4),MgO(2.2),HfO_2(0.6)$ |
| Comparative example 1 | $Si_3N_4(95),Y_2O_3(4),MgO(1)$ |
| Comparative example 2 | $Si_3N_4(92),Y_2O_3(6),MgO(0.7),HfO_2(1.3)$ |
| Comparative example 3 | $AlN(97),Y_2O_3(3)$ |

A binder and a solvent were added to the raw material powder to prepare a raw material powder slurry. The raw material powder slurry was mixed using a ball mill. The TI index of each raw material powder slurry was adjusted. The TI index was set to be within the range of not less than 2.1 and not more than 3.7 for the examples. The TI index was set to be within the range of not less than 5.5 and not more than 6.5 for the comparative examples 1 to 3. The TI index was measured in accordance with JIS-R-1665 (2005). The details of the measurement conditions were as described above. A sheet compact was made using the raw material powder slurry thus obtained. A doctor blade method was used to make the sheet compact.

A drying process was performed on the sheet compact thus obtained. The weight reduction rate of the solvent in the constant rate drying period was within the range of not less than 1 mass%/min and not more than 10 mass%/min for the examples. Also, the ratio of the weight reduction rates (the weight reduction rate of the solvent in the constant rate drying period divided by the weight reduction rate of the solvent in the reduced rate drying period) was set to be within the range of greater than 1 and not more than 20 for the examples. The weight reduction rate of the solvent in the constant rate drying period was set to be within the range of not less than 0.3 mass%/min and not more than 0.8 mass%/min for the comparative examples. Also, the ratio of the weight reduction rates (the weight reduction rate of the solvent in the constant rate drying period divided by the weight reduction rate of the solvent in the reduced rate drying period) was set to be within the range of greater than 1 and not more than 5 for the comparative examples. After the drying process, a degreasing process was performed on the sheet-like compact. The degreasing process was performed in ambient air within the range of not less than 400 °C and not more than 800 °C.

A sintering process was performed on the degreased body thus obtained. In the temperature increase process, the degreased body was held in a nonoxidizing atmosphere in the range of not less than 1,400 °C and not more than 1,650 °C for not less than 1 hour and not more than 8 hours. Subsequently, the molded body was sintered by holding the molded body within the range of not less than 1,650 °C and not more than 1,950 °C for not less than 4 hours and not more than 24 hours.

The silicon nitride substrates according to the examples and the comparative examples were made by the processes described above. The size of the silicon nitride substrate thus obtained was long side 100 mm×short side 80 mm. Also, the thermal conductivity of the silicon nitride substrate was not less than 40 W/m·K and not more than 95 W/m·K; and the three-point bending strength was not less than 500 MPa. Also, the size of the aluminum nitride substrate was long side 100 mm×short side 80 mm. The thermal conductivity of the aluminum nitride substrate was not less than 150 W/m·K and not more than 250 W/m·K; and the three-point bending strength was not less than 300 MPa and not more than 450 MPa.

An arbitrary cross section was observed by SEM for each silicon nitride substrate or aluminum nitride substrate. In the observation by SEM, an enlarged photograph of 1,000 times was imaged. Any three areas were observed. The size of the area was 180 $\mu$m×430 $\mu$m. The 90 $\mu$m×120 $\mu$m region that included the most voids was extracted from the observed areas. Image analysis software was used to determine the number and area ratio of the voids in the 90 $\mu$m×120 $\mu$m region. The number of sets of the large voids 3 of which the distances between the large voids 3 were not more than 5 $\mu$m were counted inside the 90 $\mu$m×120 $\mu$m region having the highest number of voids. The major diameters of the voids were measured in three 180 $\mu$m×430 $\mu$m areas; and the maximum diameter among the major diameters was extracted. ImageJ was used as the image analysis software. Also, the total amount of fluorine and chlorine of the silicon nitride substrate or the aluminum nitride substrate was measured. The results are shown in Table 2.

[Table 2]

| | Voids of less than 1 $\mu$m$^2$ | | Voids of not less than 1$\mu$m$^2$ | | | Maximum diameter of voids ($\mu$m) | Total amount of F and Cl (wtppm) |
|---|---|---|---|---|---|---|---|
| | Count (voids) | Area ratio (%) | Count (voids) | Area ratio (%) | Number of sets having distances of not more than 5$\mu$m | | |
| Example 1 | 78 | 0.08 | 16 | 0.3 | 1 | 6 | 287 |
| Example 2 | 157 | 0.03 | 9 | 0.1 | 2 | 11 | 54 |
| Example 3 | 484 | 0.6 | 28 | 0.6 | 3 | 14 | 114 |
| Example 4 | 312 | 0.8 | 26 | 0.5 | 3 | 15 | 366 |
| Example 5 | 204 | 0.12 | 14 | 0.2 | 1 | 7 | 47 |
| Example 6 | 223 | 0.5 | 13 | 0.5 | 2 | 8 | 189 |
| Example 7 | 310 | 0.7 | 19 | 0.7 | 2 | 12 | 103 |
| Example 8 | 45 | 0.01 | 4 | 0.1 | 0 | 5 | 17 |
| Example 9 | 491 | 0.8 | 33 | 0.6 | 4 | 15 | 763 |
| Comparative example 1 | 743 | 1.3 | 58 | 0.9 | 10 | 20 | 1055 |
| Comparative example 2 | 894 | 1.8 | 71 | 1.2 | 12 | 24 | 821 |
| Comparative example 3 | 683 | 1.6 | 62 | 1.1 | 8 | 18 | 1134 |

It can be seen from Table 2 that for the silicon nitride substrates and the aluminum nitride substrates according to the examples, the number of small voids having areas of less than 1 $\mu$m$^2$ was not less than 30 and not more than 500. The number of large voids having areas of not less than 1 $\mu$m$^2$ was within the range of not less than 0 and not more than 30.

Then, the arc discharge voltage, the dielectric breakdown voltage, and the deflection amount were measured. The methods for measuring the arc discharge voltage and the dielectric breakdown voltage were as described above. For the deflection amount, cylindrical support members having span widths of 30 mm were placed respectively at the two short-side-direction ends of the silicon nitride substrate. Stress was applied to the center portion of the substrate. The length until damage occurred was determined. The results are shown in Table 3.

[Table 3]

| | Thickness (mm) | Arc discharge voltage A(kV) | Dielectric breakdown voltage B(kV) | A/B | Deflection amount (mm) |
|---|---|---|---|---|---|
| Example 1 | 0.635 | 6.3 | 9.7 | 0.65 | 6 |
| Example 2 | 0.32 | 7.2 | 9.9 | 0.73 | 6 |
| Example 3 | 0.32 | 5.6 | 8.7 | 0.64 | 6 |

(continued)

|  | Thickness (mm) | Arc discharge voltage A(kV) | Dielectric breakdown voltage B(kV) | A/B | Deflection amount (mm) |
|---|---|---|---|---|---|
| Example 4 | 0.25 | 5.5 | 8.5 | 0.65 | 6 |
| Example 5 | 2.0 | 8.5 | 9.6 | 0.89 | 6 |
| Example 6 | 0.635 | 6.4 | 9.7 | 0.66 | 4 |
| Example 7 | 3.0 | 6.9 | 9.3 | 0.74 | 4 |
| Example 8 | 0..32 | 9.0 | 9.8 | 0.92 | 6 |
| Example 9 | 0.32 | 3.9 | 7.7 | 0.51 | 6 |
| Comparative example 1 | 0.32 | 2.2 | 9.6 | 0.23 | 6 |
| Comparative example 2 | 0.32 | 2.0 | 8.8 | 0.23 | 6 |
| Comparative example 3 | 0.635 | 1.9 | 9.2 | 0.21 | 4 |

It can be seen from Table 3 that the ratio of arc discharge voltage A/dielectric breakdown voltage B was not less than 0.3 for the silicon nitride substrates and the aluminum nitride substrates according to the examples. For the silicon nitride substrates and the aluminum nitrides substrates according to the embodiment, the arc discharge voltage was not less than 5 kV; and the dielectric breakdown voltage was not less than 8.5 kV. Also, the units can be kV/mm by dividing the dielectric breakdown voltage by the ceramic substrate thickness. For example, for the example 1, the thickness of the silicon nitride substrate was 0.32 mm, and so the dielectric breakdown voltage of the silicon nitride substrate was 30.3 kV/mm. Also, the dielectric breakdown voltage was not less than 9.3 kV for the aluminum nitride substrates according to the examples. For the examples, good results were obtained for the deflection amount as well. Also, for the example 9, $A/B$ decreased slightly and was 0.51 when the void amount and/or the fluorine content was high.

It can be seen that the dielectric breakdown voltage of the ceramic substrate was maintained and the arc discharge voltage was improved for the examples. Therefore, the long-term reliability of the insulative properties of the silicon nitride substrate and the aluminum nitride substrate was increased.

In contrast, for the comparative examples 1, 2, and 3, the dielectric breakdown voltage was equal to that of the examples, but the arc discharge voltage was lower. This was because the number of voids, the area ratio, etc., were outside the favorable ranges. On this point, the silicon nitride substrates and the aluminum nitride substrates according to the examples realized both long-term reliability of the insulative properties and cost suppression.

Embodiments of the invention may include the following features.

Feature 1

A ceramic substrate, comprising:

a ratio $A/B$ of an arc discharge voltage A to a dielectric breakdown voltage B of not less than 0.3 when the arc discharge voltage A (kV) is measured when an arc discharge is detected when applying an alternating current voltage of 50 Hz or 60 Hz between a front surface and a back surface of the ceramic substrate at a voltage increase rate of 200 V/s, and when the dielectric breakdown voltage B (kV) between the front surface and the back surface is measured according to IEC 672-2. Feature 2
The ceramic substrate according to claim 1, wherein
a thickness of the ceramic substrate is within a range of not less than 0.2 mm and not more than 3 mm.

Feature 3

The ceramic substrate according to claim 1 or claim 2, wherein
there is a 90 $\mu$m $\times$ 120 $\mu$m region in any cross section in which:

a number of first voids having areas of less than 1 $\mu$m$^2$ is within a range of not less than 30 and not more than 500; and
a number of second voids having areas of not less than 1 $\mu$m$^2$ is within a range of not less than 0 and not more than 30.

Feature 4

A ceramic substrate, wherein

a thickness of the ceramic substrate is within a range of not less than 0.2 mm and not more than 3 mm, and there is a 90 $\mu$m$\times$120 $\mu$m region in any cross section in which:

a number of first voids having areas of less than 1 $\mu$m$^2$ is within a range of not less than 30 and not more than 500; and
a number of second voids having areas of not less than 1 $\mu$m$^2$ is within a range of not less than 0 and not more than 30.

Feature 5

The ceramic substrate according to claim 3 or 4, wherein
a total area ratio of the first voids in the 90 $\mu$m$\times$120 $\mu$m region is within a range of not less than 0.01% and not more than 0.8%.

Feature 6

The ceramic substrate according to any one of claims 3 to 5, wherein
a total area ratio of the second voids in the 90 $\mu$m$\times$120 $\mu$m region is within a range of not less than 0% and not more than 0.6%.

Feature 7

The ceramic substrate according to any one of claims 3 to 6, wherein
a maximum diameter of voids in the 90 $\mu$m$\times$120 $\mu$m region is not more than 15 $\mu$m.

Feature 8

The ceramic substrate according to any one of claims 3 to 7, wherein
a number of sets of the first voids of which distances between the first voids are not more than 5 $\mu$m in the 90 $\mu$m$\times$120 $\mu$m region is not more than 3.

Feature 9

The ceramic substrate according to any one of claims 1 to 8, wherein
the ceramic substrate is a silicon nitride substrate of which the arc discharge voltage A is not less than 5 kV.

Feature 10

The ceramic substrate according to any one of claims 1 to 9, wherein
the ceramic substrate is a silicon nitride substrate having a thickness of not less than 0.2 mm and not more than 3 mm.

Feature 11

A ceramic circuit substrate, comprising:

the ceramic substrate according to any one of claims 1 to 10; and
a metal part located at a surface of the ceramic substrate.

Feature 12

A semiconductor device, comprising:

the ceramic circuit substrate according to claim 11; and
a semiconductor element mounted to the metal part.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

[Reference Numeral List]

1 ceramic substrate
2 cross section
3 void having area of not less than 1 $\mu$m$^2$
4 void having area of less than 1 $\mu$m$^2$
5 metal part
6 bonding layer
10 ceramic circuit substrate

**Claims**

1. A ceramic substrate (1), comprising:
   a ratio *A*/*B* of an arc discharge voltage A to a dielectric breakdown voltage B of not less than 0.3 when the arc discharge voltage A (kV) is measured when an arc discharge is detected when applying an alternating current voltage of 50 Hz or 60 Hz between a front surface and a back surface of the ceramic substrate (1) at a voltage increase rate of 200 V/s, and when the dielectric breakdown voltage B (kV) between the front surface and the back surface is measured according to IEC 672-2.

2. The ceramic substrate (1) according to claim 1, wherein
   a thickness of the ceramic substrate (1) is within a range of not less than 0.2 mm and not more than 3 mm.

3. The ceramic substrate (1) according to claim 1, wherein
   there is a 90 $\mu$m$\times$120 $\mu$m region in any cross section (2) in which:

   a number of first voids (4) having areas of less than 1 $\mu$m$^2$ is within a range of not less than 30 and not more than 500; and
   a number of second voids (3) having areas of not less than 1 $\mu$m$^2$ is within a range of not less than 0 and not more than 30.

4. A ceramic substrate (1), wherein

   a thickness of the ceramic substrate (1) is within a range of not less than 0.2 mm and not more than 3 mm, and there is a 90 $\mu$m$\times$120 $\mu$m region in any cross section (2) in which:

   a number of first voids (4) having areas of less than 1 $\mu$m$^2$ is within a range of not less than 30 and not more than 500; and
   a number of second voids (3) having areas of not less than 1 $\mu$m$^2$ is within a range of not less than 0 and not more than 30.

5. The ceramic substrate (1) according to claim 3 or 4, wherein
   a total area ratio of the first voids (4) in the 90 $\mu$m$\times$120 $\mu$m region is within a range of not less than 0.01% and not more than 0.8%.

6. The ceramic substrate (1) according to claim 5, wherein
   a total area ratio of the second voids (3) in the 90 $\mu$m$\times$120 $\mu$m region is within a range of not less than 0% and not more than 0.6%.

**7.** The ceramic substrate (1) according to claim 6, wherein
a maximum diameter of voids in the 90 $\mu$m×120 $\mu$m region is not more than 15 $\mu$m.

**8.** The ceramic substrate (1) according to claim 7, wherein
a number of sets of the first voids (4) of which distances between the first voids (4) are not more than 5 $\mu$m in the 90 $\mu$m×120 $\mu$m region is not more than 3.

**9.** The ceramic substrate (1) according to claim 1 or claim 4, wherein
the ceramic substrate (1) is a silicon nitride substrate of which the arc discharge voltage A is not less than 5 kV.

**10.** The ceramic substrate (1) according to claim 3 or claim 4, wherein
the ceramic substrate (1) is a silicon nitride substrate having a thickness of not less than 0.2 mm and not more than 3 mm.

**11.** The ceramic substrate (1) according to claim 8, wherein
the ceramic substrate (1) is a silicon nitride substrate having a thickness of not less than 0.2 mm and not more than 3 mm.

**12.** A ceramic circuit substrate (10), comprising:

the ceramic substrate (1) according to claim 1 or claim 4; and
a metal part (5) located at a surface of the ceramic substrate (1).

**13.** A ceramic circuit substrate (10), comprising:

the ceramic substrate (1) according to claim 10; and
a metal part (5) located at a surface of the ceramic substrate (1).

**14.** A ceramic circuit substrate (10), comprising:

the ceramic substrate (1) according to claim 11; and
a metal part (5) located at a surface of the ceramic substrate (1).

**15.** A semiconductor device, comprising:

the ceramic circuit substrate (10) according to claim 12; and
a semiconductor element mounted to the metal part (5).

**16.** A semiconductor device, comprising:

the ceramic circuit substrate (10) according to claim 13; and
a semiconductor element mounted to the metal part (5).

**17.** A semiconductor device, comprising:

the ceramic circuit substrate (10) according to claim 14; and
a semiconductor element mounted to the metal part (5).

FIG. 1

FIG. 2

FIG. 3

FIG. 4

## INTERNATIONAL SEARCH REPORT

International application No.

**PCT/JP2023/030371**

| A. | CLASSIFICATION OF SUBJECT MATTER |
|---|---|

*C04B 35/587*(2006.01)i; *C04B 35/581*(2006.01)i; *H01L 23/13*(2006.01)i; *H01L 23/15*(2006.01)i; *H05K 1/03*(2006.01)i
FI: C04B35/587; H05K1/03 610D; H01L23/14 C; H01L23/12 C; C04B35/581

According to International Patent Classification (IPC) or to both national classification and IPC

| B. | FIELDS SEARCHED |
|---|---|

Minimum documentation searched (classification system followed by classification symbols)

C04B35/587; C04B35/581; H01L23/13; H01L23/15; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2017/170247 A1 (HITACHI METALS LTD) 05 October 2017 (2017-10-05) paragraphs [0001]-[0002], [0044], [0086]-[0089], table 1, example 7 | 1-7, 9, 10, 12, 13, 15, 16 |
| A | entire text, all drawings | 8, 11, 14, 17 |
| X | JP 2022-010369 A (HITACHI METALS LTD) 14 January 2022 (2022-01-14) paragraphs [0001]-[0002], [0038], [0088]-[0090], tables 2-1, 2-2, reference example 7 | 1-7, 9, 10, 12, 13, 15, 16 |
| A | entire text, all drawings | 8, 11, 14, 17 |
| X | WO 2013/146789 A1 (HITACHI METALS LTD) 03 October 2013 (2013-10-03) paragraphs [0001]-[0002], [0057]-[0058], [0061], example 18, tables 4-1 | 1-7, 9, 10, 12, 13, 15, 16 |
| A | entire text, all drawings | 8, 11, 14, 17 |
| X | JP 2014-073937 A (HITACHI METALS LTD) 24 April 2014 (2014-04-24) paragraphs [0001], [0018]-[0021], [0028]-[0029], [0034], table 3, example 6 | 4-17 |
| A | entire text, all drawings | 1-3 |
| A | WO 2016/117553 A1 (TOSHIBA KK) 28 July 2016 (2016-07-28) entire text, all drawings | 1-17 |

☑ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 October 2023** | **07 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2023/030371**

### C. DOCUMENTS CONSIDERED TO BE RELEVANT

| Category* | Citation of document, with indication, where appropriate, of the relevant passages | Relevant to claim No. |
|---|---|---|
| A | JP 2002-185092 A (TOSHIBA KK) 28 June 2002 (2002-06-28)<br>entire text, all drawings | 1-17 |
| A | JP 2013-182983 A (DENKI KAGAKU KOGYO KK) 12 September 2013 (2013-09-12)<br>entire text, all drawings | 1-17 |
| A | JP 2001-298074 A (IBIDEN CO LTD) 26 October 2001 (2001-10-26)<br>entire text, all drawings | 1-17 |

Form PCT/ISA/210 (second sheet) (January 2015)

## INTERNATIONAL SEARCH REPORT
### Information on patent family members

| International application No. |
| --- |
| **PCT/JP2023/030371** |

| Patent document cited in search report | | | Publication date (day/month/year) | Patent family member(s) | | | Publication date (day/month/year) |
| --- | --- | --- | --- | --- | --- | --- | --- |
| WO | 2017/170247 | A1 | 05 October 2017 | US 2019/0031566 A1 paragraphs [0001]-[0002], [0060], [0119]-[0122], table 1, example 7 EP 3438075 A1 CN 108495831 A | | | |
| JP | 2022-010369 | A | 14 January 2022 | (Family: none) | | | |
| WO | 2013/146789 | A1 | 03 October 2013 | (Family: none) | | | |
| JP | 2014-073937 | A | 24 April 2014 | (Family: none) | | | |
| WO | 2016/117553 | A1 | 28 July 2016 | US 2018/0002237 A1 entire text, all drawings EP 3248956 A1 CN 107207366 A | | | |
| JP | 2002-185092 | A | 28 June 2002 | (Family: none) | | | |
| JP | 2013-182983 | A | 12 September 2013 | (Family: none) | | | |
| JP | 2001-298074 | A | 26 October 2001 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6293772 B

- JP 5928896 B